# EUROPÄISCHE PATENTSCHRIFT

(11) **EP 4 413 643 B1**
(45) Veröffentlichungstag und Bekanntmachung des Hinweises auf die Patenterteilung: **20.08.2025**
(21) Anmeldenummer: 22826314.1
(22) Anmeldetag: 18.11.2022
(51) Int. Cl.: H02J 1/08, H02J 1/14, H02J 3/00, H02M 7/12, H02M 7/06, H02M 7/219

(54) **MEHRKANAL-TESTSYSTEM MIT GALVANISCHER KOPPLUNG VON ZWISCHENKREISEN UND VERFAHREN ZUR GALVANISCHEN KOPPLUNG VON ZWISCHENKREISEN**
MULTICHANNEL TEST SYSTEM WITH GALVANIC COUPLING OF INTERMEDIATE CIRCUITS, AND METHOD FOR GALVANICALLY COUPLING INTERMEDIATE CIRCUITS
SYSTÈME DE TEST MULTICANAL AVEC COUPLAGE GALVANIQUE DE CIRCUITS INTERMÉDIAIRES ET PROCÉDÉ DE COUPLAGE GALVANIQUE DE CIRCUITS INTERMÉDIAIRES

(30) Priorität: 19.11.2021 AT 509282021
(43) Veröffentlichungstag der Anmeldung: 14.08.2024
(73) Patentinhaber: AVL List GmbH, 8020 Graz (AT)
(72) Erfinder: PUMBERGER, Michael, 8010 Graz (AT); KÖNIG, Oliver, 8042 Graz (AT); SEIDL, Manfred, 8330 Mühldorf (AT); ORNIG, Johannes, 8020 Graz (AT)
(86) Internationale Anmeldenummer: PCT/AT2022/060403
(87) Internationale Veröffentlichungsnummer: WO 2023/087044

(56) Entgegenhaltungen:
- WO-A2-2014/026840
- DE-A1- 102014 224 686
- US-A1- 2020 176 994

## Beschreibung

Die vorliegende Erfindung betrifft Mehrkanal-Testsysteme und ein Verfahren zur Versorgung von Testverbrauchervorrichtungen mit elektrischer Leistung aus einem Versorgungsnetz, die eine Kopplung von gleichstromführenden Zwischenkreisen aus galvanisch getrennten Testkanälen umfassen.

Derartige Mehrkanal-Testsysteme finden beispielsweise Anwendung in der Entwicklung und stationären Testung oder Prüfung von elektrischen Antriebsystemen oder elektrischen Board-Systemen von Fahrzeugen, in denen mehrere zusammenwirkende elektrische Baugruppen, insbesondere Verbraucher und Speicher, wie Traktionsmotoren und Traktionsbatterien sowie Nebenaggregate für Klimatisierung oder dergleichen, in Testläufen auf einem Prüfstand mit elektrischer Leistung aus einem Versorgungsnetz gespeist werden. Testsysteme mit mehreren Kanälen stellen dabei eine höhere Flexibilität bereit, da sie über mehrere Kanalausgänge parallel eine individuelle Leistungszufuhr mit konfigurierbarer Spannung bedarfsgerecht für verschiedene Prüflinge auf dem Prüfstand ermöglichen. In den jeweiligen Kanälen erfolgt eine individuell einstellbare oder steuerbare Spannungswandlung zwischen einer Wechselspannung des Netzes und einer Gleichspannung bzw. Gleichstrom für einen angeschlossenen Verbraucher.

Es sind dementsprechende Mehrkanal-Testsysteme, wie beispielsweise aus der US 2020/176994 A1 bekannt, in deren Schaltung eine galvanische Trennung zwischen den Kanälen vorgesehen ist, genauer genommen ab einer individuellen Leistungsstufe jedes Kanals. Das heißt, eine Leistungstransformation von dem Netz zum Kanal oder von dem Kanal zurück in das Netz erfolgt in jedem Kanal über einen separaten Netzgleichrichter, wobei die Netzgleichrichter aller Kanäle über einen Transformator gekoppelt mit dem Netz verbunden sind.

Die galvanische Trennung hat den Vorteil, dass eine Versorgungsstabilität von Leistungsparametern eines Kanalausgangs nicht durch Schwankungen von Leistungsflüssen in parallelen Testkanälen beeinflusst werden. Dies gilt insbesondere für Messung des Isolationswiderstands gegen Erde, welche sensibel auf benachbarte Leistungsschwankungen ansprechen. Im Bereich des Kanalausgangs ist eine für den Verbraucher individuell konfigurierbare Ausgangstufe nachgeschaltet, die i.d.R. durch einen nach der Leistungstransformation erzeugten, konstanten Gleichstrom aus einem Gleichspannungszwischenkreis gespeist wird. Andererseits ist mit dem Vorteil der Versorgungsstabilität der Nachteil einer begrenzten Leistungskapazität jedes Kanals verbunden, die durch einen Anteil einer Gesamtkapazität des gemeinsam genutzten Transformators vorgegeben ist, der für jeden der parallelen Kanäle zur Verfügung gestellt wird.

Ferner sind derartige Mehrkanal-Testsysteme bekannt, in deren Schaltung ein Kanal mehrere Kanalausgänge aufweisen kann. Hierbei ist in einem mittleren Abschnitt des Kanals ein Zwischenkreis vorgesehen, der einen konstanten Gleichstrom bei einer konstanten Gleichspannung von z.B. 820V oder 1250V führt, der aus der Leistungstransformation des Netzgleichrichters gespeist wird. Der Zwischenkreis verbindet den Netzgleichrichter mit den Kanalausgängen des Kanals, wobei die individuellen Ausgangstufen der Kanalausgänge mit Gleichstrom des Netzgleichrichters gemeinsam aus dem Zwischenkreis, d.h. galvanisch gekoppelt, versorgt werden.

Die Konfiguration einer galvanisch gekoppelten Versorgung mehrerer Kanalausgänge über einen gemeinsamen Zwischenkreis des Kanals hat den Vorteil, dass ein Leistungsfluss zwischen den mit den Kanalausgängen desselben Kanals verbundenen Verbrauchern untereinander möglich ist. In dem Fall, in dem ein Verbraucher ein Speicher ist, d.h. neben einer Leistungsaufnahme auch eine Leistungsabgabe bereitstellen kann, ist es möglich, einen leistungsstarken Verbraucher vorübergehend mit einer Spitzenleistung zu versorgen, welche die Kapazität der Leistungstransformation des Kanals aus dem Netz oder eine Netzanschlussleistung des Transformators übersteigt. Andererseits ist diese vorteilhafte Kapazitätserhöhung für einen angeschlossene Verbraucher mit ausgeprägten Leistungsspitzen jedoch nur unter der genannten Konstellation eines Speichers unter den angeschlossenen Verbrauchern sowie weiteren variablen Bedingungen wie einem Speicherungszustand und -kapazität sowie zeitlich begrenzter Abhängigkeiten nutzbar.

Zumindest theoretischer Natur, wäre unter der Zielsetzung einer Erhöhung der Netzanschlussleistung, die einem leistungsstarken Verbraucher an einem Kanalausgang maximal zur Verfügung gestellt werden kann, noch eine weitere Konfiguration eines Testsystems denkbar, zu der nach Erkenntnissen der Anmelderin bislang keine Umsetzung in der Praxis bekannt geworden ist. So könnten theoretisch zwei Einkanal-Testgeräte über deren Zwischenkreise zusammengeschlossen werden, aus denen eine Ausgangsstufe oder parallel geschaltete Ausgangsstufen für den leistungsstarken Verbraucher gespeist werden. Eine Koppelung von zwei netzgespeisten Zwischenkreisen würde jedoch bei geringen Spannungsunterschieden im Bereich von Mess- und Regelungsfehlern (z.B. 0,25 % bei einer Spannung von 1200V) bereits schädigend hohe Ausgleichsströme hervorrufen. Der Problemstellung wäre nur durch einen kostenintensiven technischen Aufwand wie einem hochstromtragfähigen Schütz-Schalter in Verbindung einer verbesserten Regelungs- und präziserer Messtechnik zur Synchronisierung der Leistungstransformationen zu begegnen, welche die Zwischenkreise parallel speisen, sowie erheblichen Ausgleichsdauern während jedes Koppelungsvorgangs zur Begrenzung des Ausgleichsstroms.

Es ist eine Aufgabe der Erfindung, die genannten Nachteile von Testsystemen im Stand der Technik zu überwinden. Es ist ferner eine Aufgabe der Erfindung, ein Testsystem der eingangs genannten Art zu schaffen, das einerseits eine hohe Flexibilität bei der parallelen Bereitstellung einer individuell konfigurierbaren Leistungszufuhr an verschieden Verbrauchern auf einem Prüfstand bietet, und andererseits eine hohe Kapazität der Netzanschlussleistung sowie der Leistungstransformation für einzelne leistungsstarke Verbraucher ermöglicht. Dabei besteht darüber hinaus eine Aufgabe der vorliegenden Erfindung darin, einen zeitlichen Aufwand zur Bedienung des Testsystems bei einer Umstellung zwischen den bereitgestellten Konfigurationen anhand der technischen Merkmale gering zu halten.

Die voranstehenden Aufgaben werden durch ein Mehrkanal-Testsystem zur Versorgung von Testverbrauchervorrichtungen mit den Merkmalen des Anspruchs 1 und ein Verfahren zur Versorgung von Testverbrauchervorrichtungen mit den Schritten des Anspruchs 9 gelöst. Weitere Merkmale und Details der Erfindung ergeben sich aus den Unteransprüchen, der Beschreibung und den Zeichnungen. Dabei gelten Merkmale und Details, die im Zusammenhang mit dem erfindungsgemäßen Mehrkanal-Testsystem beschrieben sind, selbstverständlich auch im Zusammenhang mit dem erfindungsgemäßen Verfahren und jeweils umgekehrt, sodass bezüglich der Offenbarung zu den einzelnen Erfindungsaspekten stets wechselseitig Bezug genommen wird bzw. werden kann.

Erfindungsgemäß ist ein Mehrkanal-Testsystem zur Versorgung von Testverbrauchervorrichtungen mit elektrischer Leistung aus einem Versorgungsnetz vorgesehen. Das Mehrkanal-Testsystem umfasst wenigstens einen ersten Testkanal und einen zweiten Testkanal, die jeweils wenigstens einen Kanalausgang zur Bereitstellung einer Leistung mit einer vorbestimmten Ausgangsspannung für Testverbrauchervorrichtungen umfassen. Jeder der Testkanäle ist galvanisch getrennt weist jeweils eine kontrollierbare Leistungswandlerschaltung und einen Zwischenkreis sowie einen oder mehrere Kanalausgänge auf. Die kontrollierbare Leistungswandlerschaltung dient zur kontrollierten Umwandlung von elektrischer Leistung zwischen dem Versorgungsnetz und dem gleichstromführenden Zwischenkreis des Testkanals. Jeder Kanalausgang umfasst eine Ausgangsstufe, die mit dem Zwischenkreis verbunden ist, zur Umwandlung einer Gleichspannung zwischen dem Zwischenkreis und der vorbestimmten Ausgangsspannung des Kanalausgangs. Das Mehrkanal-Testsystem weist außerdem eine Schaltvorrichtung auf, die wenigstens mit den Zwischenkreisen von dem ersten Testkanal und zweiten Testkanal verbunden ist, und zur schaltbaren galvanischen Koppelung der Zwischenkreise zu einem gemeinsamen Zwischenkreis sowie zur schaltbaren galvanischen Trennung der Zwischenkreise angeordnet ist. Zudem weisen die kontrollierbaren Leistungswandlerschaltungen zumindest von dem ersten Testkanal und zweiten Testkanal eine aktive Leistungsstufe auf, die dazu eingerichtet ist, sowohl eine phasengesteuerte, variabel einstellbare Gleichrichtung in einem aktiven Betriebsmodus, als auch eine ungesteuerte, invariable Gleichrichtung in einem passiven Betriebsmodus bereitzustellen.

Analog dazu ist erfindungsgemäß Verfahren zur Versorgung von Testverbrauchervorrichtungen mit elektrischer Leistung aus einem Versorgungsnetz mittels eines Mehrkanal-Testsystem mit wenigstens zwei galvanisch getrennten Testkanälen vorgesehen. Ein Schritt des Verfahrens besteht in einem Umwandeln einer Wechselspannung zwischen dem Versorgungsnetz und jedem Testkanal mittels eines Transformators in jedem Testkanal. Ein weiterer Schritt des Verfahrens besteht in einem Gleichrichten der Wechselspannung zwischen dem Transformator und einem gleichstromführenden Zwischenkreis mittels einer aktiven Leistungsstufe in jedem Testkanal, wobei das Gleichrichten zwischen einem phasengesteuerten, variabel einstellbaren Gleichrichten mittels eines aktiven Betriebsmodus und einem ungesteuerten invariablen Gleichrichten mittels eines passiven Betriebsmodus der aktiven Leistungsstufe überführbar ist. Ein weiterer Schritt des Verfahrens besteht in einem Umwandeln einer Gleichspannung zwischen dem gleichstromführenden Zwischenkreis und einer vorbestimmten Ausgangsspannung für Testverbrauchervorrichtungen mittels wenigstens einer Ausgangsstufe in jedem Testkanal. Ein weiterer Schritt des Verfahrens besteht in einem galvanischen Koppeln von Zwischenkreisen von wenigstens zwei Testkanälen zu einem gemeinsamen Zwischenkreis oder einem galvanischen Trennen der Zwischenkreise mittels einer Schaltvorrichtung, unter der Bedingung, dass zuvor das Gleichrichten in den aktiven Leistungsstufen der wenigstens zwei Testkanäle mittels des passiven Betriebsmodus in das ungesteuerte, invariable Gleichrichten überführt worden ist.

Die vorliegende Erfindung stellt somit erstmals eine Schaltungsarchitektur für ein Mehrkanal-Testsystem mit einer schaltbaren Koppelung und Trennung von Zwischenkreisen aus galvanisch getrennten Testkanälen bereit. Die vorliegende Erfindung sieht insbesondere eine derartige Schaltungsarchitektur mit galvanisch getrennten Transformatoren vor. Dazu schlägt die vorliegende Erfindung erstmals technische Voraussetzungen und eine Betriebsweise zur begünstigten Handhabung der schaltbaren Koppelung und Trennung von Zwischenkreisen vor.

Ein Vorteil der Erfindung liegt in der flexiblen Konfiguration, welche das Mehrkanal-Testsystem ermöglicht. Wenn von jedem Testkanal nur eine Ausgangstufe für einen Kanalausgang in Verbindung mit einem Verbraucher versorgt wird, ist dieser galvanisch isoliert und wird nicht durch Leistungsschwankungen in anderen Testkanälen beeinflusst. Somit können die Testkanäle des erfindungsgemäßen Mehrkanal-Testsystems im Sinne und mit den spezifischen Vorzügen von mehreren Einkanal-Testgeräten betrieben werden. Bei Anwendungen eines Testbetriebs, in denen eine galvanische Isolation keine Relevanz spielt, kann ein Leistungsausgleich zwischen Ausgangsstufen von Kanalausgängen in Verbindung mit Verbrauchern unterschiedlicher Art direkt über den Zwischenkreis erfolgen, ohne eine Leistungstransformation zum Versorgungsnetz.

Ein weiterer Vorteil der Erfindung liegt in der flexiblen Erhöhung der bereitstellbaren Leistungskapazität für einen einzelnen Verbraucher durch eine schaltbare Zusammenlegung aller Komponenten aus zwei galvanisch getrennten Testkanälen.

Bei einer galvanischen Koppelung der Zwischenkreise solcher zwei Testkanäle, wird ein gemeinsamer Zwischenkreis mit den kombinierten Kapazitäten aus einer verfügbaren Netzanschlussleistung von zwei oder mehr Transformatoren und einer verfügbaren Leistungstransformation aus zwei oder mehr Leistungswandlerschaltungen gespeist. Somit können eine oder mehrere parallel geschaltete Ausgangsstufen, die in Verbindung mit einem leistungsstarken Verbraucher wie einem elektrischen Traktionsantrieb stehen, mit hoher Reserve an Leistungskapazität gespeist werden, wobei auch hohe Leistungsschwankungen allein über den Netzanschluss des Mehrkanal-Testsystems abgedeckt werden können. Mit anderen Worten, ist ein Kanalausgang nicht mehr durch die zugeordnete Leistungskapazität des Kanals in einem Mehrkanal-Testsystem oder die Leistung eines Transformators in einem Einkanal-Testgerät beschränkt.

Ein wiederum weiterer Vorteil besteht in einer praxisgerechten Handhabung und schnellen Umrüstung zwischen Einkanal- bzw. Mehrkanal-Schaltungskonfigurationen des Testsystems für unterschiedliche Testbetriebe. Ein Aspekt der vorliegenden Erfindung basiert auf der Erkenntnis, dass eine sehr gute Annäherung von Zwischenkreisspannungen und somit ein geringes Ausgleichspotential in einem passiven Betrieb der Netzgleichrichter für die Leistungstransformation in den Leistungswandlerschaltungen bzw. deren aktiven Leistungsstufen erzielbar ist. Denn nach einem Stoppen der Netzgleichrichter nimmt die zunächst geregelte Zwischenkreisspannung einen passiven Gleichrichtwert ein, der sich unter einer passiven, ungeregelten Gleichrichtung im Sinne einer Diode, in einem Gleichgewicht zwischen den Schaltungskomponenten einstellt. Dieser passive Modus wird nach einem aktiven Modus eines Reglers eines geregelten Netzgleichrichters gezielt und schnell erreicht, indem die eigentlich konstante Zwischenkreisspannung auf einen passiven Wert aktiv abgesenkt und dann die Regelung gestoppt wird. Demzufolge ist in der Praxis keine Wartezeit erforderlich, um den passiven Modus durch Selbstentladung des Zwischenkreises zu erreichen.

Aufgrund der gemeinsamen Netzspannung kann die Abweichung der Zwischenkreisspannungen in diesem Betriebspunkt nur noch durch Wicklungsverhältnisse von Spulen der Transformatoren beeinflusst werden. Bei gleichen Komponententypen und Eigenschaften zwischen den Kanälen, tritt demnach nur eine minimale Abweichung zwischen den Spannungen auf, die unterhalb derjenigen liegt, die bei höherem Regelungs- und Messaufwand während des aktiven Betriebs zwischen geregelten Spannungen erzielbar wäre.

Dementsprechend kann ein Ausgleichsstrom gering gehalten werden, d.h. ohne Vorladeschaltung, welche das Schütz vor hohen Strömen beim Schaltvorgang schützt . Zudem ergibt sich eine erhebliche Zeitersparnis, da durch das aktive Absenken der Spannung in den passiven Modus keine Wartezeit erforderlich ist, um den Zwischenkreis von selbst Entladen zu lassen. Somit kann in der Praxis der gesamte Vorgang von einigen Minuten auf wenige Sekunden verkürzt werden. Zusammengefasst, bedeutet das Vorsehen einer passiven, ungeregelten Gleichrichtung, d.h. sowohl die Bereitstellung eines entsprechenden Betriebsmodus in einer Leistungswandlerschaltung bzw. einer darin umfassten aktiven Leistungsstufe des erfindungsgemäßen Mehrkanal-Testsystems, als auch die Aufstellung einer entsprechenden Bedingung und vorübergehende Nutzung der Betriebsweise in dem erfindungsgemäßen Verfahren, einen erhebliche Zeitvorteil bei einer Umrüstung des Testsystems zwischen Einkanal- bzw. Mehrkanal-Schaltungskonfigurationen. Mit anderen Worten ermöglicht das Vorsehen einer passiven, ungeregelten Gleichrichtung die genannte Umrüstung mittels eines bedienungsfreundlichen Schaltvorgangs unter geringem regelungs- und messtechnischen Aufwand.

In einer Ausführungsform umfassen die kontrollierbare Leistungswandlerschaltungen der galvanisch getrennten Testkanäle einen vorgeschalteten Transformator und eine nachgeschaltete aktive Leistungsstufe. Der Transformator, der mit dem Versorgungsnetz verbunden ist, dient zur Umwandlung einer Wechselspannung zwischen dem Versorgungsnetz und dem Testkanal. Die aktive Leistungsstufe, die mit dem Transformator verbunden ist, dient zur Gleichrichtung der Wechselspannung zwischen dem Transformator und dem gleichstromführenden Zwischenkreis, und stellt den aktiven Betriebsmodus zur phasengesteuerten, variabel einstellbaren Gleichrichtung sowie den passiven Betriebsmodus zur ungesteuerten, invariablen Gleichrichtung bereit.

In einer alternativen Ausführungsform umfassen die kontrollierbare Leistungswandlerschaltungen der galvanisch getrennten Testkanäle eine vorgeschaltete aktive Leistungsstufe und einen nachgeschalteten Zwischenkreisspannungsregler. Die aktive Leistungsstufe, der mit dem Versorgungsnetz verbunden ist, dient zur Umwandlung einer Wechselspannung zwischen dem Versorgungsnetz und dem Testkanal; und stell den aktiven Betriebsmodus zur phasengesteuerten, variabel einstellbaren Gleichrichtung sowie den passiven Betriebsmodus zur ungesteuerten, invariablen Gleichrichtung bereit. Der Zwischenkreisspannungsregler, der mit der aktiven Leistungsstufe (12, 22, 32) verbunden ist, dient zur kontrollierten Umwandlung einer Gleichspannung zwischen der aktiven Leistungsstufe und dem gleichstromführenden Zwischenkreis.

**In** einer vorteilhaften Ausführungsform der vorliegenden Erfindung weist das Mehrkanal-Testsystem ferner eine Kontrolleinheit auf, die dazu eingerichtet ist, eine galvanische Koppelung oder Trennung von Zwischenkreisen mittels der Schaltvorrichtung zu schalten oder eine Schaltungsbetätigung bereitzustellen, wenn in den aktiven Leistungsstufen der betreffenden Testkanäle die Gleichrichtung in den passiven Betriebsmodus überführt worden ist.

In einer weiteren vorteilhaften Ausführungsform der vorliegenden Erfindung weist das Mehrkanal-Testsystem zudem Spannungssensoren zur Erfassung einer Spannung von Zwischenkreisen auf; wobei die Kontrolleinheit ferner dazu eingerichtet ist, eine galvanische Koppelung oder Trennung von Zwischenkreisen mittels der Schaltvorrichtung zu schalten oder eine Schaltungsbetätigung bereitzustellen, wenn die Spannungen in den Zwischenkreisen einen jeweiligen oder einen gemeinsamen vorbestimmten Schwellwert Su erreichen.

Gemäß einem vorteilhaften Aspekt der vorliegenden Erfindung ist der jeweilige oder gemeinsame Schwellwert Su in Bezug zu einem Erreichen eines passiven Spannungspegels des jeweiligen Zwischenkreises, der sich in einem Gleichgewicht der Spannungs-Umwandlungen des jeweiligen Testkanals in dem passiven Betriebsmodus der Gleichrichtung selbst einstellt, vorbestimmt.

In einer vorteilhaften Ausführungsform der vorliegenden Erfindung weisen wenigstens der erste Testkanal und zweite Testkanal jeweils einen Transformator und eine aktive Leistungsstufe mit gleichen Umwandlungseigenschaften auf, wodurch sich ein im Wesentlichen gleicher passiver Spannungspegel in den jeweiligen Zwischenkreisen einstellt, und wobei ein gemeinsamer Schwellwert Su in Bezug zu einem Erreichen des passiven Spannungspegels vorbestimmt ist.

In einer vorteilhaften Ausführungsform der vorliegenden Erfindung weist das Mehrkanal-Testsystem zudem einen Zeitgeber zur Vorgabe einer vorbestimmten Zeitdauer auf; wobei die Kontrolleinheit ferner dazu eingerichtet ist, die Gleichrichtung von dem passiven Betriebsmodus in den aktiven Betriebsmodus zurück zu überführen oder eine Überführungsbetätigung freizugeben, wenn nach einem Abschluss eines Schaltvorgangs zur galvanische Koppelung oder Trennung von Zwischenkreisen eine vorgegebene Zeitdauer abgelaufen ist.

Gemäß einem Aspekt der vorliegenden Erfindung ist die Kontrolleinheit ferner dazu eingerichtet, eine galvanische Koppelung oder Trennung der Zwischenkreise mittels der Schaltvorrichtung zu schalten oder eine Schaltungsbetätigung bereitzustellen, wenn eine Versorgung aller Testverbrauchervorrichtungen aus einem zugeordneten Zwischenkreis unterbrochen worden ist.

In einer vorteilhaften Ausführungsform der vorliegenden Erfindung weist jede Ausgangsstufe einen Trennschalter auf, der zur schaltbaren Trennung des Kanalausgangs von dem zugeordneten Zwischenkreis oder zur schaltbaren Trennung des Kanalausgangs von einer zugeordneten Testverbrauchervorrichtung angeordnet ist; und die Kontrolleinheit ist ferner dazu eingerichtet ist, eine Trennung von wenigstens denjenigen Kanalausgängen, die mit einer Testverbrauchervorrichtung verbunden sind, mittels der Trennschalter zu schalten oder eine Schaltungsbetätigung bereitzustellen.

Weitere Vorteile, Merkmale und Einzelheiten der Erfindung ergeben sich aus der nachfolgenden Beschreibung, in der unter Bezugnahme auf die Zeichnung, Ausführungsbeispiele der Erfindung im Einzelnen beschrieben sind. Dabei können die in den Ansprüchen und in der Beschreibung erwähnten Merkmale jeweils einzeln für sich oder in beliebiger Kombination erfindungswesentlich sein.
- Fig. 1: zeigt ein Blockschaltbild, das eine Schaltung von Komponenten des Mehrkanal-Testsystems gemäß einer ersten Ausführungsform der Erfindung.
- Fig. 2: zeigt ein Blockschaltbild, das eine Schaltung von Komponenten des Mehrkanal-Testsystems gemäß einer zweiten Ausführungsform der Erfindung.

### Ausführliche Beschreibung von Ausführungsformen der Erfindung

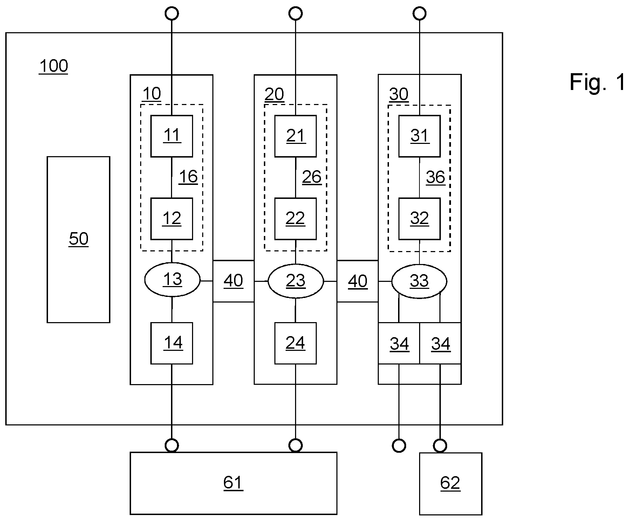

In Fig. 1 ist eine erste erfindungsgemäße Ausführungsform eines Mehrkanal-Testsystems 100 mit drei parallelen Testkanälen 10, 20, 30 schematisch in einem Blockschaltbild skizziert. Das Mehrkanal-Testsystem 100 dient zur Versorgung von Testverbrauchervorrichtungen 61, 62 mit elektrischer Leistung aus einem Versorgungsnetz (nicht dargestellt). Hierzu weist das Mehrkanal-Testsystem 100 Netzanschlüsse auf, die zu einer Oberseite schematisch dargestellt sind. Zu einer Unterseite sind Kanalausgänge dargestellt, die in unterschiedlicher Belegung einzeln oder auch in Parallelschaltung mit den verschiedenen Testverbrauchervorrichtungen 61, 62 verbunden bzw. angeschlossen werden.

Die Testverbrauchervorrichtungen 61, 62 können Komponenten eines elektrischen Antriebssystem auf einem Prüfstand sein, das verschiedenen Testläufen unterzogen wird. Dabei können die Testverbrauchervorrichtungen 61, 62 unterschiedlicher Art sein, wie ein Elektromotor oder auch eine Batterie. In dem abgebildeten Ausführungsbeispiel ist die Testverbrauchervorrichtungen 61 ein vergleichsweise leistungsstarker Traktionsmotor, der aus den zwei Testkanälen 10 und 20 mit Leistung versorgt wird, und die Testverbrauchervorrichtungen 62 ist ein kleinerer Elektromotor, der beispielsweise einen Kompressor einer Klimaanlage repräsentiert. Dabei führen die Testkanäle 10 und 20 an dem betreffenden Kanalausgang nicht nur eine andere Leistung, sondern auch eine andere, höhere Ausgangsspannung bzw. erforderliche Betriebsspannung an der Testverbrauchervorrichtungen 61 zu als der Testkanal 30 an der Testverbrauchervorrichtungen 62. Die Leistungsparameter wie die Ausgangsspannung sind anhand der Testkanäle 10, 20, 30 individuell konfigurierbar.

Die Schaltung des Testkanals 10 umfasst in einem leitungseingangsseitigen Abschnitt eine kontrollierbare Leistungswandlerschaltung (16), die in dieser ersten Ausführungsform aus einem vorgeschalteten Transformator 11 und einer nachgeschalteten aktiven Leistungsstufe besteht. Der Transformator 11 ist ein AC/AC-Wandler, der über den Netzanschluss mit dem Versorgungsnetz verbunden ist. Der Transformator 11 wandelt eine Wechselspannung von der Netzspannung in eine Systemspannung um und versorgt die aktive Leistungsstufe 12. Die aktive Leistungsstufe 12 ist ein kontrollierbarer AC/DC-Wandler, der die Wechselspannung der Systemspannung in eine Gleichspannung eines Gleichstroms umwandelt und einen Zwischenkreis 13 des Testkanals 10 speist. Die aktive Leistungsstufe 12 verfügt über einen geregelten Netzgleichrichter (MR), der einerseits die Funktion eines AC/DC-Wandlers übernimmt. Ferner verfügt sie über eine phasengesteuerte Gleichrichtung mit variabler Leistungstransformation, die eine angeforderte bzw. bedarfsgerechte Leistung bei einer vorbestimmbaren geregelten Spannung für den Zwischenkreis erzeugt. Darüber hinaus verfügt der geregelte Netzgleichrichter über zwei Betriebsmodi und eine Vielzahl von dazwischen liegenden Übergangs-Betriebszuständen bezüglich einer Betriebsweise der Gleichrichtung von Wechselspannung auf Gleichspannung. In einem aktiven Betriebszustand der aktiven Leistungsstufe 12 führt der geregelte Netzgleichrichter die zuvor beschriebene, phasengesteuerte Gleichrichtung mit variabler Leistungstransformation durch. In einem passiven Betriebszustand der aktiven Leistungsstufe 12 führt der geregelte Netzgleichrichter eine ungesteuerte Gleichrichtung durch, die der Funktion und Betriebsweise einer passiven Schaltung mit einer Diode entspricht. Aus dem Zwischenkreis 13 wird eine Ausgangsstufe 14 versorgt. Die Ausgangsstufe 14 ist insbesondere ein Tiefsetzsteller (STDC), der die von der aktiven Leistungsstufe 12 in den Zwischenkreis 13 eingespeiste Spannung in eine spezifische bzw. individuell vorbestimmte Ausgangsspannung des bestreffenden Kanalausgangs für die damit verbundene Testverbrauchervorrichtungen 61 umwandelt.

Der Testkanal 20 entspricht in der Ausführungsform der Erfindung dem Testkanal 10 und weist nicht nur den gleichen schematischen Schaltungsaufbau, sondern auch die gleichen Komponenten und Umwandlungseigenschaften in Bezug auf eine identische Bauteiltypisierung des Transformators 21, der aktiven Leistungsstufe 22 bzw. des darin umfassten, geregelten Netzgleichrichters, und optional, hinsichtlich der Kanalbelegung des abgebildeten Ausführungsbeispiels, auch der Ausgangsstufe 24 auf. Der Testkanal 30 entspricht in der Ausführungsform der Erfindung ebenfalls dem Testkanal 10 in Bezug auf eine identische Bauteiltypisierung des Transformators 31, der aktiven Leistungsstufe 32 bzw. des darin umfassten, geregelten Netzgleichrichters. In dem dargestellten Ausführungsbeispiel der Kanalbelegung unterscheidet sich zum Zwecke der Darstellung von Konfigurationsmöglichkeiten der Testkanal 30 von den Testkanälen 10 und 20 darin, dass er optional zwei Kanalausgänge mit jeweils einer zugeordneten Ausgangsstufe 34 aufweist, von denen einer unbelegt ist und einer mit der Testverbrauchervorrichtung 62 verbunden ist. Dabei werden beide Ausgangsstufen 34, die optional in unterschiedlichen Ausgangsspannungen konfigurierbar sind, aus dem gleichen Zwischenkreis 33 des Testkanals 30 versorgt. Die drei Testkanäle 10, 20, 30 sind galvanisch getrennt, d.h. dass insbesondere alle gleichstromführenden Komponenten der Schaltung jedes Testkanals 10, 20, 30, und in der vorliegenden Ausführungsform auch die Transformatoren 11, 21, 31 ohne Quereinflüsse parallel zueinander geführt sind.

Das Mehrkanal-Testsystem 100 weist ferner eine Schaltvorrichtung 40 auf, die mit dem Zwischenkreis 13 des ersten Testkanals 10, dem Zwischenkreis 23 des ersten Testkanals 20 und dem Zwischenkreis 33 des ersten Testkanals 30 in Verbindung steht. Durch unterschiedliche Schaltungsstellungen der Schaltvorrichtung 40 können der Zwischenkreis 13 und der Zwischenkreis 23, oder der Zwischenkreis 23 und der Zwischenkreis 33, oder der Zwischenreis 13 und der Zwischenkreis 33, oder auch alle drei Zwischenkreise 13, 23, 33 zu einem gemeinsamen Zwischenkreis zusammengeschlossen, das heißt galvanisch gekoppelt werden. Die Schaltvorrichtung 40 ist durch einen Schütz bzw. Schütz-Schalter realisiert.

Ein derart gekoppelter, gemeinsamer Zwischenkreis in einem Zusammenschluss von zwei oder drei Testkanälen 10, 20, 30 hat zur Folge, dass auch die Kanalausgänge bzw. deren Ausgangsstufen 14, 24, 34 miteinander galvanisch gekoppelt sind, d.h. eine Leistungsaufteilung mit ausgleichendem Leistungsfluss unter den Testkanälen 10, 20, 30 über den gemeinsamen Zwischenkreis erfolgt. Andererseits ermöglicht ein derart gekoppelter, gemeinsamer Zwischenkreis eine Verdoppelung bzw. Verdreifachung einer aus dem Versorgungsnetz abrufbaren und ausgangsseitig verfügbaren Leistungskapazität für eine der Testverbrauchervorrichtungen 61, 62, ohne dass prinzipiell ein neuer Schaltungsaufbau des Testsystems 100 errichtet oder ein größer dimensionierter Transformator zum Umbau des Testsystems 100 vorgehalten werden muss.

Bei der Kanalbelegung des in Fig. 1 dargestellten Ausführungsbeispiels stellt die Testverbrauchervorrichtungen 61 einen leistungsstarken Verbraucher wie einen Traktionsmotor dar, für den in einem Testbetrieb unter Volllast ausreichende Leistungsreserven bereitgestellt werden sollen. Dementsprechend sind in dem dargestellten Ausführungsbeispiel die Zwischenkreise 13 und 23 über die Schaltvorrichtung 40 zu einem gemeinsamen Zwischenkreis zusammengeschlossen. Damit sind die Ausgangsstufen 14 und 24 bzw. die Kanalausgänge der Testkanäle 10 und 20, die gemeinsam eine Leistung an der Testverbrauchervorrichtung 61 zuführen, galvanisch gekoppelt. Der Zwischenkreis 33 des Testkanals 30 ist in dem dargestellten Ausführungsbeispiels hingegen nicht durch die Schaltvorrichtung 40 gekoppelt worden, womit die beiden Ausgangsstufen 34 zwar untereinander galvanisch gekoppelt bleiben, jedoch von den Ausgangsstufen 14, 24 galvanisch getrennt sowie von den hohen Leistungsflüssen durch die Testkanäle 10 und 20 unbeeinflusst bleiben.

Abweichend von Fig. 1 kann in einer funktional gleichwertigen Schaltung ebenso lediglich ein Kanalausgang von dem Testkanal 10 oder von dem Testkanal 20 mit der Testverbrauchervorrichtung 61 verbunden sein.

Ferner umfasst das Mehrkanal-Testsystem 100 eine Kontrolleinheit 50, die zur Kontrolle, d.h. im Sinne der vorliegenden Offenbarung zur Steuerung und/oder Regelung der Schaltvorgänge der Schaltvorrichtung 40 sowie der zuvor beschriebenen Betriebsweisen der Gleichrichtung der geregelten Netzgleichrichter in den in den kontrollierbaren Leistungswandlerschaltungen (16, 26, 36), d.h. genauer genommen in den aktiven Leistungsstufen 12, 22, 32 der kontrollierbaren Leistungswandlerschaltungen (16, 26, 36) dient. Dazu ist die Kontrolleinheit 50 vorzugsweise über ein Bedienungsinterface zur Betätigung von Änderungen der Schaltungskonfiguration, insbesondere zur Durchführung von Koppelungen und Trennungen der Zwischenschaltkreise 13, 23, 33 ansteuerbar. Dabei ist aus verfahrenstechnischen Aspekten der vorliegenden Erfindung ferner vorgesehen, dass die Kontrolleinheit 50 eine Durchführung von Schaltvorgängen der Schaltvorrichtung 40 oder eine äußere Betätigung eines Nutzers hierzu nur unter bestimmten Voraussetzungen, insbesondere unter dem zuvor beschriebenen passiven Betriebsmodus der Gleichrichtung in den beteiligten Testkanälen 10, 20, 30 durchführt oder freigibt bzw. zulässt.

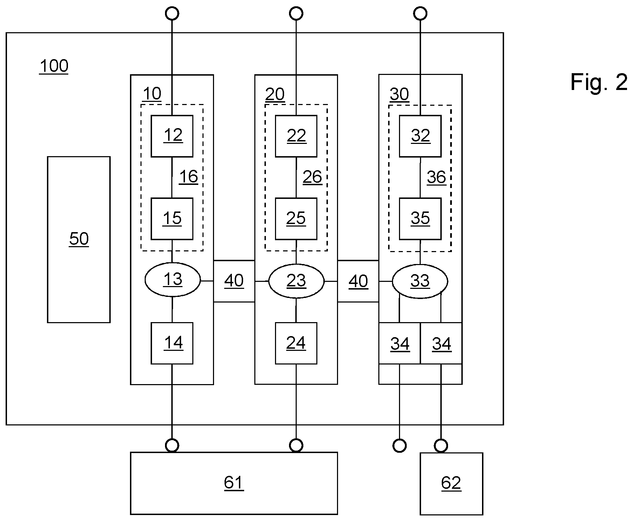

In Fig. 2 ist eine zweite erfindungsgemäße Ausführungsform des Mehrkanal-Testsystems 100 mit drei parallelen Testkanälen 10, 20, 30 schematisch in einem Blockschaltbild skizziert. Das Mehrkanal-Testsystem 100 der zweiten Ausführungsform in Fig. 2 unterscheidet sich von der ersten Ausführungsform aus Fig. 1 lediglich im Aufbau der kontrollierbaren Leistungswandlerschaltungen (16, 26, 36). Funktional wird in der zweiten Ausführungsform zunächst eine AC/DC-Umwandlung und nachgeschaltet eine DC/DC-Umwandlung realisiert, anstelle einer AC/AC-Umwandlung und einer nachgeschalteten AC/DC-Umwandlung, wie in der ersten Ausführungsform.

Hierzu ist in jedem Testkanal (10, 20, 30) jeweils die aktive Leistungsstufe (12, 22, 32), die ein kontrollierbarer AC/DC-Wandler ist, direkt mit dem Versorgungsnetz verbunden (d.h. ohne vorgeschalteten Transformator). Die aktive Leistungsstufe wandelt eine Wechselspannung des Versorgungsnetzes in eine gleichgerichtete Systemspannung um und versorgt einen Zwischenkreisspannungsregler (15, 25, 35). Der Zwischenkreisspannungsregler (15, 25, 35) ist ein galvanisch trennender DC/DC-Wandler, der die Gleichspannung der gleichgerichteten Systemspannung in eine Gleichspannung des gleichstromführenden Zwischenkreises (13, 23, 33) des jeweiligen Testkanals (10, 20, 30) umwandelt. Abgesehen von der abweichenden Schaltungsposition der aktiven Leistungsstufe (12, 22, 32) in der zweiten Ausführungsform, verfügt diese entsprechend der ersten Ausführungsform wiederum über einen geregelten Netzgleichrichter (MR), der die Funktion eines AC/DC-Wandlers übernimmt, und über eine phasengesteuerte Gleichrichtung mit variabler Leistungstransformation, die eine angeforderte bzw. bedarfsgerechte Leistung bei einer vorbestimmbaren geregelten Spannung für den Zwischenkreis erzeugt. Ebenso verfügt der geregelte Netzgleichrichter in der zweiten Ausführungsform ebenso wie in der ersten Ausführungsform über zwei Betriebs-modi und eine Vielzahl von dazwischen liegenden Übergangs-Betriebszuständen bezüglich einer Betriebsweise der Gleichrichtung von Wechselspannung auf Gleichspannung. In einem aktiven Betriebszustand der aktiven Leistungsstufe 12 führt der geregelte Netzgleichrichter die zuvor beschriebene, phasengesteuerte Gleichrichtung mit variabler Leistungstransformation durch. In einem passiven Betriebszustand der aktiven Leistungsstufe 12 führt der geregelte Netzgleichrichter eine ungesteuerte Gleichrichtung durch, die der Funktion und Betriebsweise einer passiven Schaltung mit einer Diode entspricht.

In der ersten und zweiten Ausführungsform des Mehrkanal-Testsystems 100 aus den Figuren 1 und 2 kann eine Überprüfung der betriebstechnischen Voraussetzungen für einen Schaltvorgang durch optionale weitere messtechnische Maßnahmen und Bedingungen unterstützt werden, wie nachstehend beschrieben ist. Optional ist jedoch eine Bedienung des erfindungsgemäßen Mehrkanal-Testsystems 100 auch ohne die nachfolgenden Funktionen sowie ohne die Kontrolleinheit 50, lediglich durch Bereitstellung geeigneter Betätigungselemente und der Einhaltung einer Logik von Bedienungsschritten manuell betreibbar, insbesondere umschaltbar.

Zur Sicherstellung geringer und kurzer Ausgleichsströme erfolgt jeder Schaltvorgang der Schaltvorrichtung 40, insbesondere bei der Koppelung, im Zustand ausgeschalteter Ausgangsstufen 14, 24, 34, um die Spannungen in den Zwischenkreisen 13, 23, 33 stabil zu halten. Dieser Vorgang kann manuell, wie beispielsweise durch vorgesehene Trennschalter erfolgen.

Die Schaltvorgänge der Schaltvorrichtung 40 zur Umstellung der Schaltungskonfiguration können ohne eine Trennung des Mehrkanal-Testsystems 100 vom Versorgungsnetz durchgeführt werden. Aus einem aktiven Betriebsmodus der Gleichrichtung werden zunächst durch die geregelten Netzgleichrichter der aktiven Leistungsstufen 12, 22, 32 der an der Koppelung beteiligten Testkanäle 10, 20, 30 die Zwischenkreisspannungen aktiv bis nahezu einem passiven Gleichrichtwert abgesenkt. Das aktive Absenken kann relativ schnell erfolgen, z.B. von 1250 V auf 1045 V in einigen 100 ms, da dies von einer gewählten Spannungsrampe in einer Zwischenkreisspannungsregelungsfunktion der aktiven Leistungsstufen 12, 22, 32 gemäß der ersten Ausführungsform, bzw. anhand eines Zwischenkreisspannungsreglers (15, 25, 35) gemäß der zweiten Ausführungsform, abhängig ist. Wenn anschließend die geregelten Netzgleichrichter in den passiven Betriebszustand überführt worden sind, wird kurz abgewartet, bis sich die geregelten Zwischenkreisspannung durch weitere passive Entladung bis zu dem passiven Gleichrichtwert bzw. einem Spannungsgleichgewicht abgesenkt haben.

Während das Absenken auf den passiven Betriebsmodus der geregelten Netzgleichrichter in den Leistungsstufen 12, 22, 32 beim Schließen des der Schaltvorrichtung 40 sicherstellt, dass die Spannungen der Zwischenkreise vor dem Schließen exakt und ruhig sind, stellt dementsprechend das Absenken auf passiven Betriebsmodus beim Trennen der Schaltvorrichtung 40 sicher, dass die aktive Regelung der Netzgleichrichter in den Leistungsstufen 12, 22, 32 im Moment des Öffnens keinerlei Querströme über die Schaltvorrichtung 40, d.h. das Schütz fließen lassen.

Hierzu kann manuell oder seitens der Kontrolleinheit 50 mittels Spannungssensoren eine Spannungserfassung an den Zwischenkreisen 13, 23, 33 erfolgen und eine Unterschreitung aller Spannungen unter einen Schwellwert Su erfasst werden, der in Bezug zu dem Gleichrichtwert angenähert bzw. vordefiniert ist. Alternativ kann manuell oder seitens der Kontrolleinheit 50 eine vordefinierte Zeitdauer abgewartet werden, nach deren Ablauf von der gewünschten Spannungsannäherung auszugehen ist.

Nach einem erfolgten Schaltvorgang der Schaltvorrichtung 40 werden manuell oder seitens der Kontrolleinheit 50 die geregelten Netzgleichrichter der aktiven Leistungsstufen 12, 22, 32 der an der Koppelung beteiligten Testkanäle 10, 20, 30 von dem passiven Betriebszustand wieder zurück in den aktiven Betriebszustand überführt. Ein Spannungszeiger des Versorgungsnetzes wird während des gesamten passiven Betriebszustandes verfolgt. Die Kontrolleinheit 50 hebt einen Sollwert einzelner oder gekoppelter Zwischenkreise 13, 23, 33 an und eine Software der Regler der Netzgleichrichter in den Leistungsstufen 12, 22, 32 erkennt über einen Vergleich zwischen Sollwert und passivem Wert, dass ein aktives Schalten von Leistung erforderlich ist. Infolgedessen wird eine Spannung des gemeinsamen Zwischenkreises von dem passiven Gleichrichtwert zu einer vorbestimmten geregelten Spannung, die gemäß einer neuen Konfiguration des Mehrkanal-Testsystems 100 vordefiniert ist, hochgefahren.

Alternativ zu den beschriebenen Schaltvorgängen ist auch ein Trennen der Zwischenkreise möglich, wenn beide Gleichrichter ohnehin ausgeschalten sind.

Mit der galvanischen Kopplung der Zwischenkreise 13, 23, 33 geht eine logische Kopplung der Netzgleichrichterregelung einher, welche einen Betrieb ohne dynamische Einschränkungen ermöglicht.

Vorzugsweise wird der Schaltvorgang des Koppelns und Trennens durch die Kontrolleinheit 50, d.h. von zentraler Stelle im System vorgegeben, welche auch die Benutzerinteraktion und die Schaltungs- bzw. Schützsteuerung übernimmt.

Die voranstehenden Erläuterungen der Ausführungsformen beschreiben die vorliegende Erfindung ausschließlich im Rahmen von Beispielen. Selbstverständlich können einzelne Merkmale der Ausführungsformen, sofern technisch sinnvoll, frei miteinander kombiniert werden, ohne den Rahmen der vorliegenden Erfindung zu verlassen.

### Bezugszeichenliste

- 10: Testkanal
- 11: Transformator (AC/AC-Wandler)
- 12: aktive Leistungsstufe (AC/DC-Wandler)
- 13: Zwischenkreis
- 14: Ausgangsstufe
- 15: Zwischenkreisspannungsregler (DC/DC-Wandler)
- 16: kontrollierbare Leistungswandlerschaltung (AC/AC+AC/DC-Wandler oder AC/DC+DC/DC-Wandler)
- 20: Testkanal
- 21: Transformator
- 22: aktive Leistungsstufe
- 23: Zwischenkreis
- 24: Ausgangsstufe
- 30: Testkanal
- 31: Transformator
- 32: aktive Leistungsstufe
- 33: Zwischenkreis
- 34: Ausgangsstufe
- 40: Schaltvorrichtung
- 50: Kontrolleinheit
- 61: Testverbrauchervorrichtung
- 62: Testverbrauchervorrichtung
- 100: Mehrkanal-Testsystem

- Su: Schwellwert für Zwischenkreisspannungen
- S_{I}: Schwellwert für Ausgleichstrom

## Patentansprüche

1. Mehrkanal-Testsystem (100) zur Versorgung von Testverbrauchervorrichtungen (61, 62) mit elektrischer Leistung aus einem Versorgungsnetz, mit
wenigstens einem ersten Testkanal (10) und einem zweiten Testkanal (20), die jeweils wenigstens einen Kanalausgang zur Bereitstellung einer Leistung mit einer vorbestimmten Ausgangsspannung für Testverbrauchervorrichtungen (61, 62) umfassen, wobei die Testkanäle (10, 20, 30) galvanisch getrennt sind;
und jeder Testkanal (10, 20, 30) eine Leistungswandlerschaltung (16, 26, 36) aufweist zur kontrollierten Umwandlung von elektrischer Leistung zwischen dem Versorgungsnetz und einem gleichstromführenden Zwischenkreis (13, 23, 33) des Testkanals (10, 20, 30);jeder Kanalausgang eine Ausgangsstufe (14, 24, 34) umfasst, die mit dem Zwischenkreis (13, 23, 33) verbunden ist, zur Umwandlung einer Gleichspannung zwischen dem Zwischenkreis (13, 23, 33) und der vorbestimmten Ausgangsspannung des Kanalausgangs; und
wenigstens eine Schaltvorrichtung (40), die wenigstens mit den Zwischenkreisen (13, 23) von dem ersten Testkanal (10) und zweiten Testkanal (20) verbunden ist, und zur schaltbaren galvanischen Koppelung der Zwischenkreise (13, 23) zu einem gemeinsamen Zwischenkreis sowie zur schaltbaren galvanischen Trennung der Zwischenkreise (13, 23) angeordnet ist; wobei
wenigstens die Leistungswandlerschaltungen (16, 26) von dem ersten Testkanal (10) und zweiten Testkanal (20) eine aktive Leistungsstufe (12, 22) aufweisen, die dazu eingerichtet ist, sowohl eine phasengesteuerte, variabel einstellbare Gleichrichtung einer Wechselspannung in einem aktiven Betriebsmodus, als auch eine ungesteuerte, invariable Gleichrichtung in einem passiven Betriebsmodus bereitzustellen.

2. Mehrkanal-Testsystem (100) nach Anspruch 1, wobei die kontrollierbaren Leistungswandlerschaltungen (16, 26, 36) der galvanisch getrennten Testkanäle (10, 20, 30) umfassen:
einen vorgeschalteten Transformator (11, 21, 31), der mit dem Versorgungsnetz verbunden ist, zur Umwandlung einer Wechselspannung zwischen dem Versorgungsnetz und dem Testkanal (10, 20, 30); und
nachgeschaltet, die aktive Leistungsstufe (12, 22, 32), die mit dem Transformator (11, 21, 31) verbunden ist, zur Gleichrichtung der Wechselspannung zwischen dem Transformator (11, 21, 31) und dem gleichstromführenden Zwischenkreis (13, 23, 33), und welche den aktiven Betriebsmodus zur phasengesteuerten, variabel einstellbaren Gleichrichtung sowie den passiven Betriebsmodus zur ungesteuerten, invariablen Gleichrichtung bereitstellt.

3. Mehrkanal-Testsystem (100) nach Anspruch 1, wobei die kontrollierbaren Leistungswandlerschaltungen (16, 26, 36) der galvanisch getrennten Testkanäle (10, 20, 30) umfassen:
vorgeschaltet, die aktive Leistungsstufe (12, 22, 32), die mit dem Versorgungsnetz verbunden ist, zur Umwandlung einer Wechselspannung zwischen dem Versorgungsnetz und dem Testkanal (10, 20, 30); und welche den aktiven Betriebsmodus zur phasengesteuerten, variabel einstellbaren Gleichrichtung sowie den passiven Betriebsmodus zur ungesteuerten, invariablen Gleichrichtung bereitstellt; und
einen nachgeschalteten Zwischenkreisspannungsregler (15, 25, 35), der mit der aktiven Leistungsstufe (12, 22, 32) verbunden ist, zur kontrollierten Umwandlung einer Gleichspannung zwischen der aktiven Leistungsstufe (12, 22, 32) und dem gleichstromführenden Zwischenkreis (13, 23, 33).

4. Mehrkanal-Testsystem (100) nach einem der Ansprüche 1 bis 3, ferner aufweisend eine Kontrolleinheit (50), wobei
die Kontrolleinheit (50) dazu eingerichtet ist, eine galvanische Koppelung oder Trennung von Zwischenkreisen (13, 23, 33) mittels der Schaltvorrichtung (40) zu schalten oder eine Schaltungsbetätigung bereitzustellen, wenn in den aktiven Leistungsstufen (12, 22) der betreffenden Testkanäle (10, 20, 30) die Gleichrichtung in den passiven Betriebsmodus überführt worden ist.

5. Mehrkanal-Testsystem (100) nach Anspruch 4, ferner aufweisend Spannungssensoren zur Erfassung einer Spannung von Zwischenkreisen (13, 23, 33); wobei
die Kontrolleinheit (50) ferner dazu eingerichtet ist, eine galvanische Koppelung oder Trennung von Zwischenkreisen (13, 23, 33) mittels der Schaltvorrichtung (40) zu schalten oder eine Schaltungsbetätigung bereitzustellen, wenn die Spannungen in den Zwischenkreisen (13, 23, 33) einen jeweiligen oder einen gemeinsamen vorbestimmten Schwellwert Su erreichen.

6. Mehrkanal-Testsystem (100) nach Anspruch 5, wobei der jeweilige oder gemeinsame Schwellwert Su in Bezug zu einem Erreichen eines passiven Spannungspegels des jeweiligen Zwischenkreises (13, 23, 33), der sich in einem Gleichgewicht der Spannungs-Umwandlungen des jeweiligen Testkanals (10, 20, 30) in dem passiven Betriebsmodus der Gleichrichtung selbst einstellt, vorbestimmt ist.

7. Mehrkanal-Testsystem (100) nach Anspruch 5 oder 6, wobei wenigstens der erste Testkanal (10) und zweite Testkanal (20) jeweils einen Transformator (11, 21) und eine aktive Leistungsstufe (12, 22) mit gleichen Umwandlungseigenschaften aufweisen, wodurch sich ein im Wesentlichen gleicher passiver Spannungspegel in den jeweiligen Zwischenkreisen (13, 23) einstellt, und wobei ein gemeinsamer Schwellwert Su in Bezug zu einem Erreichen des passiven Spannungspegels vorbestimmt ist.

8. Mehrkanal-Testsystem (100) nach Anspruch 1 bis 7, ferner aufweisend einen Zeitgeber zur Vorgabe einer vorbestimmten Zeitdauer; wobei
die Kontrolleinheit (50) ferner dazu eingerichtet ist, die Gleichrichtung von dem passiven Betriebsmodus in den aktiven Betriebsmodus zurück zu überführen oder eine Überführungsbetätigung freizugeben, wenn nach einem Abschluss eines Schaltvorgangs zur galvanische Koppelung oder Trennung von Zwischenkreisen (13, 23, 33) eine vorgegebene Zeitdauer abgelaufen ist.

9. Mehrkanal-Testsystem (100) nach Anspruch 1 bis 8, wobei die Kontrolleinheit (50) ferner dazu eingerichtet ist, eine galvanische Koppelung oder Trennung der Zwischenkreise (13, 23, 33) mittels der Schaltvorrichtung (40) zu schalten oder eine Schaltungsbetätigung bereitzustellen, wenn eine Versorgung aller Testverbrauchervorrichtungen (61, 62) aus einem zugeordneten Zwischenkreis (13, 23, 33) unterbrochen worden ist.

10. Mehrkanal-Testsystem (100) nach Anspruch 1 bis 9, wobei jede Ausgangsstufe (14, 24, 34) einen Trennschalter aufweist, der zur schaltbaren Trennung des Kanalausgangs von dem zugeordneten Zwischenkreis (13, 23, 33) oder zur schaltbaren Trennung des Kanalausgangs von einer zugeordneten Testverbrauchervorrichtung (61, 62) angeordnet ist.

11. Verfahren zur Versorgung von Testverbrauchervorrichtungen (61, 62) mit elektrischer Leistung aus einem Versorgungsnetz mittels eines Mehrkanal-Testsystem (100) mit wenigstens zwei galvanisch getrennten Testkanälen (10, 20, 30), aufweisend die Schritte:
Umwandeln von elektrischer Leistung zwischen dem Versorgungsnetz und einem gleichstromführenden Zwischenkreis (13, 23, 33) jedes Testkanals (10, 20, 30) mittels einer Leistungswandlerschaltung (16, 26, 36); darunter die Zwischenschritte:
Gleichrichten der Wechselspannung zwischen einem Transformator (11, 21, 31) und einem gleichstromführenden Zwischenkreis (13, 23, 33) oder Gleichrichten der Wechselspannung zwischen dem Versorgungsnetz und einem Zwischenkreisspannungsregler (15, 25, 35), mittels einer aktiven Leistungsstufe (12, 22, 32) in jedem Testkanal (10, 20, 30);
wobei das Gleichrichten zwischen einem phasengesteuerten, variabel einstellbaren Gleichrichten mittels eines aktiven Betriebsmodus und einem ungesteuerten invariablen Gleichrichten mittels eines passiven Betriebsmodus der aktiven Leistungsstufe (12, 22, 32) überführbar ist;
Umwandeln einer Gleichspannung zwischen dem gleichstromführenden Zwischenkreis (13, 23, 33) und einer vorbestimmten Ausgangsspannung für Testverbrauchervorrichtungen (61, 62) mittels wenigstens einer Ausgangsstufe (14, 24, 34) in jedem Testkanal (10, 20, 30); und
galvanisches Koppeln von Zwischenkreisen (13, 23, 33) von wenigstens zwei Testkanälen (10, 20, 30) zu einem gemeinsamen Zwischenkreis oder galvanisches Trennen der Zwischenkreise (13, 23, 33) mittels einer Schaltvorrichtung (40), wenn
das Gleichrichten in den aktiven Leistungsstufen (12, 22, 33) der wenigstens zwei Testkanäle (10, 20, 30) mittels des passiven Betriebsmodus in das ungesteuerte, invariable Gleichrichten überführt worden ist.

12. Verfahren nach Anspruch 11, ferner aufweisend den Zwischenschritt:
Erfassen einer Spannung von Zwischenkreisen (13, 23, 33) mittels Spannungssensoren; und
galvanisches Koppeln von Zwischenkreisen (13, 23, 33) von wenigstens zwei Testkanälen zu einem gemeinsamen Zwischenkreis oder galvanisches Trennen der Zwischenkreise (13, 23, 33) mittels einer Schaltvorrichtung (40), wenn die Spannungen in den Zwischenkreisen (13, 23, 33) einen jeweiligen oder einen gemeinsamen vorbestimmten Schwellwert Su erreichen.

13. Verfahren nach Anspruch 12, wobei der jeweilige oder gemeinsame Schwellwert Su in Bezug zu einem Erreichen eines passiven Spannungspegels des jeweiligen Zwischenkreises (13, 23, 33), der sich in einem Gleichgewicht der Spannungs-Umwandlungen des jeweiligen Testkanals (10, 20, 30) bei dem ungesteuerten, invariablen Gleichrichten selbst einstellt, vorbestimmt ist.

14. Verfahren nach einem der Ansprüche 11 oder 13, ferner aufweisend die Schritte:
Vorgeben einer vorbestimmten Zeitdauer nach einem Abschluss eines Schaltvorgangs zur galvanische Koppelung oder Trennung der Zwischenkreise (13, 23, 33); und
Überführen des ungesteuerten, invariablen Gleichrichtens in das phasengesteuerte, variabel einstellbare Gleichrichten mittels Überführen der aktiven Leistungsstufen (12, 22, 32) von dem passiven Betriebsmodus zurück in den aktiven Betriebsmodus, wenn die vorgegebene Zeitdauer abgelaufen ist.

15. Verfahren nach einem der Ansprüche 11 bis 14, ferner aufweisend den Zwischenschritt:
Trennen von Ausgangsstufen (14, 24, 34) von einem zugeordneten Zwischenkreis (13, 23, 33), oder Trennen von Testverbrauchervorrichtungen (61, 62) von einer zugeordneten Ausgangsstufe (14, 24, 34); und
galvanisches Koppeln von Zwischenkreisen (13, 23, 33) von wenigstens zwei Testkanälen zu einem gemeinsamen Zwischenkreis oder galvanisches Trennen der Zwischenkreise (13, 23, 33) mittels einer Schaltvorrichtung (40), wenn eine Versorgung aller Testverbrauchervorrichtungen (61, 62) unterbrochen worden ist.

## Claims

1. Multi-channel test system (100) for supplying test consumer devices (61, 62) with electrical power from a supply network, comprising at least a first test channel (10) and a second test channel (20), each comprising at least one channel output for providing power at a predetermined output voltage to test consumer devices (61, 62), wherein the test channels (10, 20, 30) are galvanically isolated;
and each test channel (10, 20, 30) comprises a power conversion circuit (16, 26, 36) for controlled conversion of electrical power between the supply network and a DC link (13, 23, 33) of the test channel (10, 20, 30);each channel output comprises an output stage (14, 24, 34) connected to the DC link (13, 23, 33) for converting a DC voltage between the DC link (13, 23, 33) and the predetermined output voltage of the channel output; and the test channels (10, 20, 30) each comprise at least one channel output for providing a power having a predetermined output voltage to test consumer devices (61, 62), wherein the test channels (10, 20, 30) are galvanically isolated; and
at least one switching device (40), which is connected at least to the intermediate circuits (13, 23) of the first test channel (10) and second test channel (20), and is arranged for the switchable galvanic coupling of the intermediate circuits (13, 23) to form a common intermediate circuit and for the switchable galvanic isolation of the intermediate circuits (13, 23); wherein
at least the power converter circuits (16, 26) of the first test channel (10) and second test channel (20) have an active power stage (12, 22) which is set up to provide both a phase-controlled, variably adjustable rectification of an AC voltage in an active operating mode and an uncontrolled, invariable rectification in a passive operating mode.

2. Multi-channel test system (100) according to claim 1, wherein the controllable power converter circuits (16, 26, 36) of the galvanically isolated test channels (10, 20, 30) comprise:
an upstream transformer (11, 21, 31), which is connected to the supply network, for converting an AC voltage between the supply network and the test channel (10, 20, 30); and
downstream, the active power stage (12, 22, 32), which is connected to the transformer (11, 21, 31), for rectifying the AC voltage between the transformer (11, 21, 31) and the DC link (13, 23, 33), and which provides the active operating mode for phase-controlled, variably adjustable rectification and the passive operating mode for uncontrolled, invariable rectification.

3. Multi-channel test system (100) according to claim 1, wherein the controllable power conversion circuits (16, 26, 36) of the galvanically isolated test channels (10, 20, 30) comprise: an active power stage (12, 22, 32) connected to the supply network for converting an AC voltage between the supply network and the test channel (10, 20, 30); and
upstream, the active power stage (12, 22, 32), which is connected to the supply network, for converting an AC voltage between the supply network and the test channel (10, 20, 30); and which provides the active operating mode for phase-controlled, variably adjustable rectification and the passive operating mode for uncontrolled, invariable rectification; and
a downstream DC link voltage regulator (15, 25, 35) connected to the active power stage (12, 22, 32) for controlled conversion of a DC voltage between the active power stage (12, 22, 32) and the DC link (13, 23, 33).

4. Multi-channel test system (100) according to one of claims 1 to 3, further comprising a control unit (50), wherein
the control unit (50) is arranged to switch a galvanic coupling or isolation of intermediate circuits (13, 23, 33) by means of the switching device (40) or to provide a circuit actuation when the rectification in the active power stages (12, 22) of the respective test channels (10, 20, 30) has been transferred to the passive operating mode.

5. Multi-channel test system (100) according to claim 4, further comprising voltage sensors for detecting a voltage of intermediate circuits (13, 23, 33); wherein
the control unit (50) is further arranged to switch a galvanic coupling or isolation of intermediate circuits (13, 23, 33) by means of the switching device (40) or to provide a circuit actuation when the voltages in the intermediate circuits (13, 23, 33) reach a respective or a common predetermined threshold value Su.

6. Multi-channel test system (100) according to claim 5, wherein the respective or common threshold Su is predetermined with respect to reaching a passive voltage level of the respective DC link (13, 23, 33) which is set in a balance of the voltage conversions of the respective test channel (10, 20, 30) in the passive operation mode of the rectification itself.

7. Multi-channel test system (100) according to claim 5 or 6, wherein at least the first test channel (10) and second test channel (20) each have a transformer (11, 21) and an active power stage (12, 22) with the same conversion characteristics, as a result of which a substantially identical passive voltage level is set in the respective intermediate circuits (13, 23), and wherein a common threshold value Su is predetermined in relation to reaching the passive voltage level.

8. Multi-channel test system (100) according to claim 1 to 7, further comprising a timer for setting a predetermined time duration; wherein
the control unit (50) is further arranged to transfer the rectification from the passive operating mode back to the active operating mode or to enable a transfer operation when a predetermined time period has elapsed after completion of a switching operation for galvanic coupling or isolation of intermediate circuits (13, 23, 33)..

9. Multi-channel test system (100) according to claim 1 to 8, wherein the control unit (50) is further arranged to switch a galvanic coupling or isolation of the intermediate circuits (13, 23, 33) by means of the switching device (40) or to provide a circuit actuation when a supply to all test consumer devices (61, 62) from an associated intermediate circuit (13, 23, 33) has been interrupted.

10. Multi-channel test system (100) according to claim 1 to 9, wherein each output stage (14, 24, 34) has an isolating switch which is arranged for the switchable isolation of the channel output from the associated intermediate circuit (13, 23, 33) or for the switchable isolation of the channel output from an associated test consumer device (61, 62).

11. Method for supplying test consumer devices (61, 62) with electrical power from a supply network by means of a multi-channel test system (100) with at least two galvanically isolated test channels (10, 20, 30), comprising the steps of
converting electrical power between the supply network and a DC link (13, 23, 33) of each test channel (10, 20, 30) by means of a power converter circuit (16, 26, 36); including the intermediate steps of:
rectifying the AC voltage between a transformer (11, 21, 31) and a DC link (13, 23, 33) or rectifying the AC voltage between the supply network and a DC link voltage regulator (15, 25, 35), by means of an active power stage (12, 22, 32) in each test channel (10, 20, 30);
wherein the rectification can be converted between a phase-controlled, variably adjustable rectification by means of an active operating mode and an uncontrolled invariable rectification by means of a passive operating mode of the active power stage (12, 22, 32);
converting a DC voltage between the DC link (13, 23, 33) and a predetermined output voltage for test consumer devices (61, 62) by means of at least one output stage (14, 24, 34) in each test channel (10, 20, 30); and
galvanically coupling intermediate circuits (13, 23, 33) of at least two test channels (10, 20, 30) to a common intermediate circuit or galvanically isolating the intermediate circuits (13, 23, 33) by means of a switching device (40), if
the rectification in the active power stages (12, 22, 33) of the at least two test channels (10, 20, 30) has been converted to uncontrolled, invariable rectification by means of the passive operating mode.

12. Method according to claim 11, further comprising the intermediate step of:
detecting a voltage of intermediate circuits (13, 23, 33) by means of voltage sensors; and
galvanically coupling intermediate circuits (13, 23, 33) of at least two test channels to form a common intermediate circuit or galvanically isolating the intermediate circuits (13, 23, 33) by means of a switching device (40) when the voltages in the intermediate circuits (13, 23, 33) reach a respective or a common predetermined threshold value Su.

13. Method according to claim 12, wherein the respective or common threshold Su is predetermined with respect to reaching a passive voltage level of the respective intermediate circuit (13, 23, 33) which is set in a balance of the voltage conversions of the respective test channel (10, 20, 30) in the uncontrolled invariable rectification itself.

14. Method according to any one of claims 11 or 13, further comprising the steps of:
predetermining a predetermined time period after a completion of a switching operation for galvanic coupling or isolation of the DC links (13, 23, 33); and
transferring the uncontrolled, invariable rectification to the phase-controlled, variably adjustable rectification by transferring the active power stages (12, 22, 32) from the passive operating mode back to the active operating mode when the predetermined time period has elapsed.

15. Method according to any one of claims 11 to 14, further comprising the intermediate step of:
separating output stages (14, 24, 34) from an associated intermediate circuit (13, 23, 33), or separating test consumer devices (61, 62) from an associated output stage (14, 24, 34); and
galvanic coupling of intermediate circuits (13, 23, 33) of at least two test channels to form a common intermediate circuit or galvanic isolation of the intermediate circuits (13, 23, 33) by means of a switching device (40) if a supply to all test consumer devices (61, 62) has been interrupted.

## Revendications

1. Système de test multicanal (100) pour alimenter des dispositifs consommateurs de test (61, 62) en puissance électrique à partir d'un réseau d'alimentation, avec
au moins un premier canal de test (10) et un deuxième canal de test (20), qui comprennent chacun au moins une sortie de canal pour fournir une puissance avec une tension de sortie prédéterminée pour des dispositifs consommateurs de test (61, 62), les canaux de test (10, 20, 30) étant séparés galvaniquement ;
et chaque canal de test (10, 20, 30) comprend un circuit de conversion de puissance (16, 26, 36) pour convertir de manière contrôlée la puissance électrique entre le réseau d'alimentation et un circuit intermédiaire à courant continu (13, 23, 33) du canal de test (10, 20, 30) ;chaque sortie de canal comprend un étage de sortie (14, 24, 34) connecté au circuit intermédiaire (13, 23, 33) pour convertir une tension continue entre le circuit intermédiaire (13, 23, 33) et la tension de sortie prédéterminée de la sortie de canal ; et
au moins un dispositif de commutation (40), qui est relié au moins aux circuits intermédiaires (13, 23) du premier canal de test (10) et du deuxième canal de test (20), et qui est disposé pour le couplage galvanique commutable des circuits intermédiaires (13, 23) en un circuit intermédiaire commun ainsi que pour la séparation galvanique commutable des circuits intermédiaires (13, 23) ; où
au moins les circuits de conversion de puissance (16, 26) du premier canal de test (10) et du deuxième canal de test (20) comprennent un étage de puissance actif (12, 22) qui est conçu pour fournir à la fois un redressement variable réglable commandé en phase d'une tension alternative dans un mode de fonctionnement actif, et un redressement invariable non commandé dans un mode de fonctionnement passif.

2. Système de test multicanal (100) selon la revendication 1, dans lequel les circuits de conversion de puissance contrôlables (16, 26, 36) des canaux de test séparés galvaniquement (10, 20, 30) comprennent :
en amont, un transformateur (11, 21, 31) connecté au réseau d'alimentation pour convertir une tension alternative entre le réseau d'alimentation et le canal de test (10, 20, 30) ; et
en aval, l'étage de puissance actif (12, 22, 32), qui est connecté au transformateur (11, 21, 31), pour redresser la tension alternative entre le transformateur (11, 21, 31) et le circuit intermédiaire à courant continu (13, 23, 33), et qui fournit le mode de fonctionnement actif pour un redressement à phase contrôlée, variable et ajustable, ainsi que le mode de fonctionnement passif pour un redressement invariable non contrôlé.

3. Système de test multicanal (100) selon la revendication 1, dans lequel les circuits de conversion de puissance contrôlables (16, 26, 36) des canaux de test (10, 20, 30) séparés galvaniquement comprennent :
en amont, l'étage de puissance actif (12, 22, 32), connecté au réseau d'alimentation, pour convertir une tension alternative entre le réseau d'alimentation et le canal de test (10, 20, 30) ; et qui fournit le mode de fonctionnement actif pour un redressement à phase contrôlée, variable et ajustable, ainsi que le mode de fonctionnement passif pour un redressement invariable non contrôlé ; et
un régulateur de tension de circuit intermédiaire en aval (15, 25, 35), connecté à l'étage de puissance actif (12, 22, 32), pour convertir de manière contrôlée une tension continue entre l'étage de puissance actif (12, 22, 32) et le circuit intermédiaire à courant continu (13, 23, 33).

4. Système de test multicanal (100) selon l'une quelconque des revendications 1 à 3, comprenant en outre une unité de contrôle (50), dans lequel
l'unité de contrôle (50) est conçue pour commuter un couplage ou une séparation galvanique de circuits intermédiaires (13, 23, 33) au moyen du dispositif de commutation (40) ou pour fournir un actionnement de commutation lorsque, dans les étages de puissance actifs (12, 22) des canaux de test concernés (10, 20, 30), le redressement a été transféré dans le mode de fonctionnement passif.

5. Système de test multicanal (100) selon la revendication 4, comprenant en outre des capteurs de tension pour détecter une tension de circuits intermédiaires (13, 23, 33) ; dans lequel
l'unité de contrôle (50) est en outre adaptée pour commuter un couplage ou une séparation galvanique de circuits intermédiaires (13, 23, 33) au moyen du dispositif de commutation (40) ou pour fournir une opération de commutation lorsque les tensions dans les circuits intermédiaires (13, 23, 33) atteignent une valeur de seuil prédéterminée respective ou commune Su.

6. Système de test multicanal (100) selon la revendication 5, dans lequel la valeur de seuil respective ou commune Su est prédéterminée par rapport à une atteinte d'un niveau de tension passive du circuit intermédiaire respectif (13, 23, 33) qui s'établit dans un équilibre des conversions de tension du canal de test respectif (10, 20, 30) dans le mode de fonctionnement passif du redressement lui-même.

7. Système de test multicanal (100) selon la revendication 5 ou 6, dans lequel au moins le premier canal de test (10) et le deuxième canal de test (20) comprennent chacun un transformateur (11, 21) et un étage de puissance actif (12, 22) ayant les mêmes caractéristiques de conversion, ce qui permet d'obtenir un niveau de tension passive sensiblement identique dans les circuits intermédiaires respectifs (13, 23), et dans lequel une valeur de seuil commune Su est prédéterminée par rapport à une atteinte du niveau de tension passive.

8. Système de test multicanal (100) selon les revendications 1 à 7, comprenant en outre une minuterie pour définir une période de temps prédéterminée; dans lequel l'unité de commande (50) est en outre conçue pour faire repasser le redressement du mode de fonctionnement passif au mode de fonctionnement actif ou pour valider une opération de transfert lorsqu'une période de temps prédéterminée s'est écoulée après l'achèvement d'une opération de commutation pour le couplage ou la séparation galvanique de circuits intermédiaires (13, 23, 33).

9. Système de test multicanal (100) selon les revendications 1 à 8, dans lequel l'unité de commande (50) est en outre adaptée pour commuter un couplage ou une déconnexion galvanique des circuits intermédiaires (13, 23, 33) au moyen du dispositif de commutation (40) ou pour fournir une opération de commutation lorsqu'une alimentation de tous les dispositifs consommateurs de test (61, 62) à partir d'un circuit intermédiaire associé (13, 23, 33) a été interrompue.

10. Système de test multicanal (100) selon les revendications 1 à 9, dans lequel chaque étage de sortie (14, 24, 34) comporte un sectionneur qui est agencé pour séparer de manière commutable la sortie du canal du circuit intermédiaire associé (13, 23, 33) ou pour séparer de manière commutable la sortie du canal d'un dispositif consommateur de test associé (61, 62).

11. Procédé d'alimentation de dispositifs consommateurs de test (61, 62) en puissance électrique à partir d'un réseau d'alimentation au moyen d'un système de test multicanal (100) comportant au moins deux canaux de test (10, 20, 30) séparés galvaniquement, comprenant les étapes consistant à :
Convertir la puissance électrique entre le réseau d'alimentation et un circuit intermédiaire à courant continu (13, 23, 33) de chaque canal de test (10, 20, 30) au moyen d'un circuit de conversion de puissance (16, 26, 36) ; dont les étapes intermédiaires:
redresser la tension alternative entre un transformateur (11, 21, 31) et un circuit intermédiaire à courant continu (13, 23, 33) ou redresser la tension alternative entre le réseau d'alimentation et un régulateur de tension de circuit intermédiaire (15, 25, 35), au moyen d'un étage de puissance actif (12, 22, 32) dans chaque canal de test (10, 20, 30) ;
le redressement pouvant être transféré entre un redressement à phase contrôlée, variable et ajustable au moyen d'un mode de fonctionnement actif et un redressement invariable non contrôlé au moyen d'un mode de fonctionnement passif de l'étage de puissance actif (12, 22, 32) ;
conversion d'une tension continue entre le circuit intermédiaire à courant continu (13, 23, 33) et une tension de sortie prédéterminée pour des dispositifs consommateurs de test (61, 62) au moyen d'au moins un étage de sortie (14, 24, 34) dans chaque canal de test (10, 20, 30) ; et
le couplage galvanique de circuits intermédiaires (13, 23, 33) d'au moins deux canaux de test (10, 20, 30) en un circuit intermédiaire commun ou la séparation galvanique des circuits intermédiaires (13, 23, 33) au moyen d'un dispositif de commutation (40), lorsque le redressement dans les étages de puissance actifs (12, 22, 33) des au moins deux canaux de test (10, 20, 30) a été transformé en redressement invariable non commandé au moyen du mode de fonctionnement passif.

12. Procédé selon la revendication 11, comprenant en outre l'étape intermédiaire :
détection d'une tension de circuits intermédiaires (13, 23, 33) au moyen de capteurs de tension ; et
coupler galvaniquement des circuits intermédiaires (13, 23, 33) d'au moins deux canaux de test en un circuit intermédiaire commun ou séparer galvaniquement les circuits intermédiaires (13, 23, 33) au moyen d'un dispositif de commutation (40) lorsque les tensions dans les circuits intermédiaires (13, 23, 33) atteignent une valeur de seuil respective ou une valeur de seuil commune prédéterminée Su.

13. Procédé selon la revendication 12, dans lequel la valeur de seuil respective ou commune Su est prédéterminée par rapport à l'atteinte d'un niveau de tension passive du circuit intermédiaire respectif (13, 23, 33) qui s'établit dans un équilibre des conversions de tension du canal de test respectif (10, 20, 30) lors du redressement invariable non commandé lui-même.

14. Procédé selon l'une des revendications 11 ou 13, comprenant en outre les étapes consistant à :
Définir une période de temps prédéterminée après l'achèvement d'une opération de commutation pour le couplage ou la séparation galvanique des circuits intermédiaires (13, 23, 33) ; et
faire passer le redressement invariable non commandé au redressement variable à commande de phase en faisant repasser les étages de puissance actifs (12, 22, 32) du mode de fonctionnement passif au mode de fonctionnement actif lorsque la période de temps prédéterminée s'est écoulée.

15. Procédé selon l'une quelconque des revendications 11 à 14, comprenant en outre l'étape intermédiaire :
déconnecter des étages de sortie (14, 24, 34) d'un circuit intermédiaire associé (13, 23, 33), ou déconnecter des dispositifs consommateurs de test (61, 62) d'un étage de sortie associé (14, 24, 34) ; et
le couplage galvanique de circuits intermédiaires (13, 23, 33) d'au moins deux canaux de test en un circuit intermédiaire commun, ou la séparation galvanique des circuits intermédiaires (13, 23, 33) au moyen d'un dispositif de commutation (40), lorsqu'une alimentation de tous les dispositifs consommateurs de test (61, 62) a été interrompue.
